**Europäisches Patentamt**

**European Patent Office**

**Office européen des brevets**

(11) Publication number: **0 153 802**
**B1**

# EUROPEAN PATENT SPECIFICATION

(45) Date of publication of patent specification: **26.07.89**

(51) Int. Cl.⁴: **H 03 K 19/094**

(21) Application number: **85300392.9**

(22) Date of filing: **21.01.85**

(54) **Logic circuits.**

(30) Priority: **20.02.84 JP 28481/84**

(43) Date of publication of application:
**04.09.85 Bulletin 85/36**

(45) Publication of the grant of the patent:
**26.07.89 Bulletin 89/30**

(84) Designated Contracting States:
**DE FR GB**

(56) References cited:
**US-A-3 911 289**
**US-A-4 185 209**

**W. CARR et al. "MOS/LSI, Design and
Applications", 1972; Mc Graw-Hill Company,
pages 125-126**

(73) Proprietor: **KABUSHIKI KAISHA TOSHIBA
72, Horikawa-cho Saiwai-ku
Kawasaki-shi Kanagawa-ken 210 (JP)**

(73) Proprietor: **Toshiba Micro-Computer
Engineering Corporation
2-11, Higashida-cho Kawasaki-ku
Kawasaki-shi Kanagawa-ken (JP)**

(72) Inventor: **Suganuma, Kazuo
5-16-26, Serigaya Kohnan-ku
Yokohama-shi Kanagawa-ken (JP)**
Inventor: **Hamai, Tsuneo
2-7-10, Kirigaoka Midori-ku
Yokohama-shi Kanagawa-ken (JP)**

(74) Representative: **Kirk, Geoffrey Thomas et al
BATCHELLOR, KIRK & EYLES 2 Pear Tree Court
Farringdon Road
London EC1R 0DS (GB)**

Courier Press, Leamington Spa, England.

## Description

This invention relates to logic circuits, such as NOR and NAND gates, for producing an output signal responsive to a plurality of input signals.

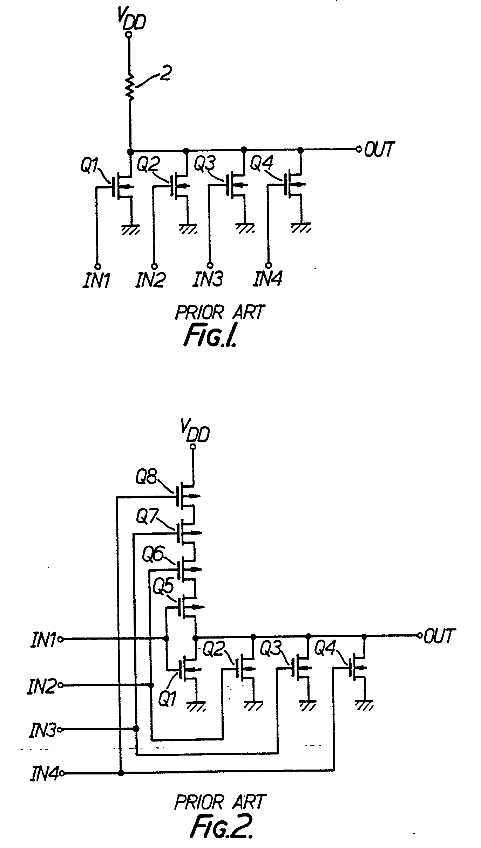

Referring now to Figure 1 of the accompanying drawings, there is shown a prior art NOR circuit having four inputs. N-channel enhancement type MOSFETs Q1, Q2, Q3 and Q4 are connected in parallel between an output terminal and ground. The gate electrodes of MOSFETs Q1, Q2, Q3 and Q4 are connected to respective input terminals IN1, IN2, IN3 and IN4. A load element 2, in the form of a resistor, is connected between a power supply terminal $V_{DD}$ and the output terminal.

In use, even if only one of the MOSFETs Q1—Q4 is rendered conductive, a current path between the power supply and ground is formed and current flows through the path. Power consumption of such a NOR circuit with a load element is very large.

Referring now to Figure 2, there is shown another prior art NOR circuit and this employs complementary MOSFETs (CMOSFETs). N-channel enhancement type MOSFETs Q1—Q4 are connected in parallel between the output terminal and ground. P-channel enhancement type MOSFETs Q5, Q6, Q7 and Q8 are connected in series between the power supply terminal $V_{DD}$ and the output terminal. The gate electrodes of MOSFETS Q1 and Q5, Q2 and Q6, Q3 and Q7, and Q4 and Q8 are connected to input terminals IN1, IN2, IN3 and IN4, respectively. When MOSFET Q1—Q4 is conductive, the corresponding MOSFET Q5—Q8 is not conductive and no current path is formed between the power supply terminal and ground. In this way, power consumption of the NOR circuit of CMOSFETs is very small. However, the total number of MOSFETs in such a circuit is twice that of input terminals. This results in complex wiring and a larger physical area than that of a NOR circuit which uses a load element. Moreover, when the logic level of the output signal responsive to input signals changes to a logic "1", the voltage of the power supply terminal is transmitted through MOSFETs Q5, Q6, Q7 and Q8. Therefore, it takes longer to change its output to a logic "1" than a ciruit with a load element.

Prior art logic circuits equivalent to those shown in Figures 1 and 2 of the specification are disclosed in Figures 4.11 and 4.12 on pages 125 and 126 of the publication "MOS/LSI Design and Application" by Carr et al.

It is an object of this invention to provide a logic circuit with low power consumption and a reduced physical area.

According to the invention, a logic circuit comprises a plurality of MOSFETs of a first conductivity type having their current conducting terminals connected in parallel between a first power terminal and an output terminal and their control terminals connected to respective input terminals, and an electrical connection between a second power terminal and said output terminal, characterised in that said connection comprises either the current conducting terminals of one MOSFET of a second conductivity type arranged with its control terminal connected to one of said input terminals or the current conducting terminals of a plurality of MOSFETs of a second conductivity type connected in series, with the control terminals of the MOSFETs connected to respective input terminals, the number of MOSFETs of the second conductivity type being less than the number of MOSFETs of the first conductivity type, and in that the channel resistance of said one MOSFET of second conductivity type or the channel resistance of the series connection of said plurality of MOSFETs is larger than that of each one of said MOSFETs of first conductivity type.

In order that the invention may be more readily understood, it will now be described, by way of example only, with reference to the accompanying drawings, in which:—

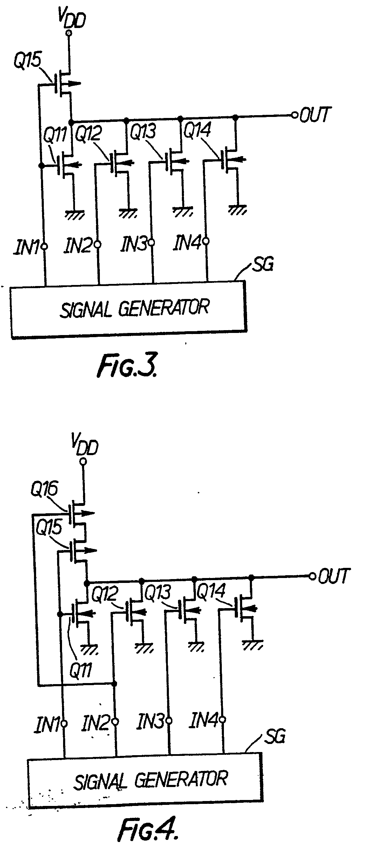

Figure 3 shows NOR circuit of a preferred embodiment of the invention;

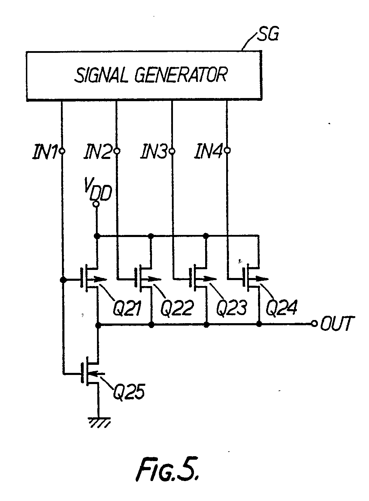

Figure 4 shows a NOR circuit of another embodiment of the invention; and

Figure 5 shows a NAND circuit of yet another embodiment of the invention.

Referring now to the drawings, there is shown in Figure 3 a NOR circuit in accordance with the present invention. N-channel enhancement type MOSFETs Q11, Q12, Q13 and Q14 are connected with their current conducting terminals in parallel between an output terminal and a ground terminal. The gate electrodes of MOSFETs Q11, Q12, Q13 and Q14 are connected to input terminals IN1, IN2, IN3 and IN4, respectively, which are, in turn, connected to signal generator SG. Signal generator SG may be any logic circuit. A P-channel enhancement type MOSFET type Q15 is connected between a power supply terminal $V_{DD}$ and the output terminal. The gate electrode of MOSFET Q15 is connected to input terminal IN1. The channel resistance of MOSFET Q15 is arranged to be greater than that of each one of MOSFETs Q11—Q14.

When the logic level of input terminal IN1 is a logic "1", MOSFET Q11 is conductive and MOS-FET Q15 is nonconductive. Therefore, the logic level of the output terminal is a logic "0", irrespective of the logic levels of input terminals IN2, IN3 and IN4. In this state, no current path between the power supply terminal and the ground terminal is formed and current does not flow.

When the logic level of input terminal IN1 is a logic "0", MOSFET Q11 is nonconductive and MOSFET Q15 is conductive. Additionally, if the logic levels of at least one of input terminals IN2, IN3 and IN4, for example IN2, is a logic "1", MOSFET Q12 is conductive and a current path through MOSFETs Q15 and Q12 between the power supply terminal and the ground terminal is formed. Therefore, the logic level of the output terminal is a logic "0". It is effective for low power consumption to make the channel resistance of MOSFET Q15 large.

When the logic level of input terminals IN1—IN4 are a logic "0", only MOSFET Q15 is conductive. Therefore, no current path is formed and the logic level of the output terminal is a logic "1".

The number of elements of this circuit is the same as that of the prior art circuit shown in Figure 1 including the resistor and is less than that of the prior art circuit shown in Figure 2. Therefore, this circuit is suitable for a large scale integrated circuit.

Since current does not flow in this circuit when the logic level of the input terminal IN1 is a logic "1", power consumption of this circuit is smaller than that of the circuit which uses a load resistor like the prior art circuit shown in Figure 1.

Usually, signal generator SG generates different input signals to be applied to input terminals IN1—IN4 and the periods of time during which the logic levels of the input signals are a logic "1" are different from each other. Bearing in mind that the current path between the power supply terminal and the ground terminal is not formed when the logic level of the input terminal IN1 is a logic "1" irrespective of the logic levels of input terminals IN2, IN3 and IN4, the power consumption of this circuit is made smallest if the input signal from signal generator SG that has the longest period during which the logic level is a logic "1" is applied to the input terminal IN1.

Moreover, the voltage of the power supply terminal is transmitted through MOSFET Q15 to the output terminal only when the logic level of all input terminals IN1—IN4 is a logic "0". Therefore, the time required to output a logic "1" is shorter than that of the prior art circuit shown in Figure 2.

Referring to Figure 4, there is shown another embodiment of this invention. This NOR circuit is identical to that of Figure 3 with the addition of P-channel MOSFET Q16 connected between the power supply terminal $V_{DD}$ and MOSFET Q15. The gate electrode of MOSFET Q16 is connected to input terminal IN2. The total resistance of the channel resistances of MOSFETs Q15 and Q16 is arranged to be greater than that of each one of MOSFETs Q11—Q14.

When the logic level of at least one of input terminals IN1 and IN2 is a logic "1", no current path between the power supply terminal and the ground terminal is formed. Therefore, power consumption of this circuit is smaller than that of the circuit shown in Figure 3.

In the embodiments shown in Figures 3 and 4, MOSFETs Q15 and Q16 are enhancement type. However, MOSFETs Q15 and Q16 may be depletion type.

Referring now to Figure 5, there is shown a NAND circuit in accordance with the present invention. P-channel enhancement type MOSFETs Q21, Q22, Q23 and Q24 are connected with the current conducting terminals in parallel between the power supply terminal $V_{DD}$ and the output terminal. The gate electrodes of MOSFETs Q21, Q22, Q23 and Q24 are connected to input terminals IN1, IN2, IN3 and IN4, respectively, which are, in turn, connected to signal generator SG. An N-channel MOSFET of enhancement type Q25 is connected between the output terminal and the ground terminal. The gate electrode of MOSFET Q25 is connected to input terminal IN1. The channel resistance of MOSFET Q25 is arranged to be larger than that of each one of MOSFETs Q21—Q24.

When the logic level of input terminal IN1 is a logic "0", MOSFET Q21 is conductive and MOSFET Q25 is nonconductive. Therefore, no current path between the power supply terminal and the ground terminal is formed and the logic level of the output terminal is a logic "1".

When the logic level of input terminal IN1 is a logic "1" and the logic level of at least one of input terminals IN2, IN3 and IN4, for example IN2, is a logic "0", MOSFETs Q22 and Q25 are conductive. Therefore, a current path between the power supply terminal and the ground terminal is formed and the logic level of the output terminal is a logic "1".

When all logic levels of input terminals IN1—IN4 are a logic "1", only MOSFET Q25 is conductive. Therefore, no current path between the power supply terminal and the ground terminal is formed and the logic level of the output terminal is a logic "0".

This NAND circuit also achieves low power consumption, small area and high speed.

While this invention has been described with reference to illustrative embodiments, this description is not intended to be construed in a limiting sense. Various modifications of the embodiments will be, apparent to persons skilled in the art upon reference to this description. It is, therefore, contemplated that the appended claims will cover any such modifications or embodiments as fall within the true scope of the invention.

## Claims

1. A logic circuit comprising a plurality of MOSFETs (Q11—Q14, Q21—Q24) of a first conductivity type having their current conducting terminals connected in parallel between a first power terminal and an output terminal and their control terminals connected to respective input terminals (IN1—IN4), and an electrical connection between a second power terminal and said output terminal, characterised in that said connection comprises either the current conducting terminals of one MOSFET (Q15, Q25) of a second conductivity type arranged with its control terminal connected to one of said input terminals or the current conducting terminals of a plurality of MOSFETs (Q15, Q16) of a second conductivity type connected in series, with the control terminals of the MOSFETs (Q15, Q16) connected to respective input terminals, the number of MOSFETs of the second conductivity type being less than the number of MOSFETs of the first conductivity type, and in that the channel resistance of said one MOSFET of second conductivity type or the channel resistance of the series connection of said plurality of MOSFETs is larger than that of each one of said MOSFETs of first conductivity type.

2. A logic circuit according to claim 1, characterised in that said MOSFETs of first conductivity type are N-channel MOSFETs and the or each MOSFET of second conductivity type is a P-channel MOSFET.

3. A logic circuit according to claim 2, characterised in that said MOSFETs are of the enhancement type.

4. A logic circuit as claimed in claim 1 or 2, characterised in that the or each MOSFET of the second conductivity type is of the depletion type.

5. A logic circuit as claimed in any preceding claim, characterised in that the first power terminal is earth.

6. A logic circuit as claimed in claim 1, characterised in that said MOSFETs of first conductivity type are P-channel MOSFETs and the or each MOSFET of second conductivity type is an N-channel MOSFET.

7. A logic circuit according to claim 6, characterised in that said MOSFETs are of the enhancement type.

8. A logic circuit according to claim 6 or 7, characterised in that the second power terminal is earth.

9. A logic circuit according to claims 1 to 5, characterised in the provision of means for generating said input signals, said generating means applying to the or one of the MOSFETs of second conductivity type, one of said input signals which has a level for a greater percentage of time than any other of said input signals, said level causing said MOSFET of second conductivity type to be non-conductive.

**Patentansprüche**

1. Logische Schaltung mit
einer Anzahl von MOSFETs (Q11—Q14, Q21—Q24) eines ersten Leitfähigkeitstyps, deren stromleitende Klemmen parallel an eine erste Versorgungsklemme und eine Ausgangsklemme angeschlossen sind und deren Steuerklemmen an entsprechenden Eingangsklemmen (IN1—IN4) angeschlossen sind, und mit einer elektrischen Verbindung zwischen einer zweiten Versorgungsklemme und der genannten Ausgangsklemme, dadurch gekennzeichnet, daß
die Verbindung entweder die stromleitenden Klemmen eines MOSFETs (Q15, Q25) eines zweiten Leitfähigkeitstyps enthält, der mit seiner Steuerklemme mit einer der genannten Eingangsklemmen oder den stromleitenden Klemmen einer Anzahl von MOSFETs (Q15, Q16) eines zweiten Leitfähigkeitstyps in Reihe geschaltet ist, wobei die Steuerklemmen der MOSFETs (Q15, Q16) mit entsprechenden Eingangsklemmen verbunden sind, wobei die Zahl der MOSFETs des zweiten Leitfähigkeitstyps geringer ist als die Zahl von MOSFETs des ersten Leitfähigkeitstyps, und daß der Channel-Widerstand des genannten einen MOSFETs des zweiten Leitfähigkeitstyps oder der Channel-Widerstand der Reihenschaltung der genannten Zahl von MOSFETs größer ist als der jedes der MOSFETs des ersten Leitfähigkeitstyps.

2. Logische Schaltung nach Anspruch 1, dadurch gekennzeichnet, daß die genannten MOSFETs des ersten Leitfähigkeitstyps N-Channel-MOSFETs und der oder jeder MOSFET des zweiten Leitfähigkeitstyps ein P-Channel-MOSFET ist.

3. Logische Schaltung nach Anspruch 2, dadurch gekennzeichnet, daß die genannten MOSFETs vom Enhancement-Typ sind.

4. Logische Schaltung nach Anspruch 1 oder 2, dadurch gekennzeichnet, daß der oder jeder MOSFET des zweiten Leitfähigkeitstyps vom Depletion-Typ ist.

5. Logische Schaltung nach einem der vorhergehenden Ansprüche, dadurch gekennzeichnet, daß die erste Versorgungsklemme Erde ist.

6. Logische Schaltung nach Anspruch 1, dadurch gekennzeichnet, daß die genannten MOSFETs des ersten Leitfähigkeitstyps P-Channel-MOSFETs und der oder jeder MOSFET des zweiten Leitfähigkeitstyps ein N-Channel MOSFET ist.

7. Logische Schaltung nach Anspruch 6, dadurch gekennzeichnet, daß die MOSFETs vom Enhancement-Typ sind.

8. Logische Schaltung nach Anspruch 6 oder 7, dadurch gekennzeichnet, daß die zweite Versorgungsklemme Erde ist.

9. Logische Schaltung nach einem der Ansprüche 1 bis 5, gekennzeichnet durch Mittel zur Erzeugung der genannten Eingangssignale, wobei die genannten Erzeugungsmittel an den oder einen der MOSFETs des zweiten Leitfähigkeitstyps eines der genannten Eingangssignale anlegen, der für einen größeren Prozentsatz an Zeit einen Pegel hat als irgendein anderes der genannten Eingangssignale, wobei der genannte Pegel den genannten MOSFET des zweiten Leitfähigkeitstyps dazu veranlaßt, nichtleitend zu sein.

**Revendications**

1. Circuit logique qui comprend plusieurs transistors MOSFET ayant un premier mode de conduction dont les bornes conductrices de courant sont branchées en paralèle entre une première borne d'alimentation et une borne de sortie et dont les bornes de commande sont connectées à des bornes d'entrée respectives, et une connexion électrique entre une seconde borne d'alimentation et ladite borne de sortie caractérisé en ce que ladite connexion comprend soit les bornes conductrices de courant d'un transistor MOSFET (Q15, Q25) ayant un second mode de conduction monté avec l'une desdites bornes d'entrée connectée à l'une desdites bornes d'entrée, soit les bornes conductrices de courant de plusieurs transistors MOSFET ayant un second mode de conduction connecté en série, les bornes de commande des transistors MOSFET (Q15, Q16) étant connectées aux bornes d'entrée respectives, le nombre des transistors MOSFET (Q15, Q16) du second mode de conduction étant inférieur à celui des transistors MOSFET du premier mode de conduction, et en ce que la résistance du canal dudit transistor MOSFET du second mode de conduction ou la résistance de canal du circuit série composé desdits transistors MOSFET est plus grande que celle de chacun des transistors MOSFET ayant le premier mode de conduction.

2. Circuit logique selon la revendication 1, caractérisé en ce que lesdits transistors MOSFET du premier mode de conduction sont des MOSFET du type à canal N, tandis que le ou chacun des transistors MOSFET ayant le second mode de conduction sont du type à canal P.

3. Circuit logique selon la revendication 2, caractérisé en ce que lesdits transistors MOSFET sont du type à enrichissement.

4. Circuit logique selon la revendication 2, caractérisé en ce que les ou chacun des transistors MOSFET ayant le second mode de conduction sont du type à raréfaction.

5. Circuit logique selon l'une quelconque des revendications précédentes, caractérisé en ce que la première borne d'alimentation est la terre.

6. Circuit logique selon la revendication 1, caractérisé en ce que lesdits transistors MOSFET du premier mode de conduction sont des transistors MOSFET à canal P, tandis que le ou chacun des transistors MOSFET du second mode de conduction sont du type à canal N.

7. Circuit logique selon la revendication 6, caractérisé en ce que lesdits transistors MOSFET sont du type à enrichissement.

8. Circuit logique selon la revendication 6 ou 7, caractérisé en ce que la seconde borne d'alimentation est la terre.

9. Circuit logique selon l'une quelconque des revendications 1 à 5, caractérisé par la présence de moyens pour générer lesdits signaux d'entrée, lesdits moyens appliquant aux ou à l'un des transistors MOSFET ayant le second mode de conduction, l'un desdits signaux d'entrée qui a un certain niveau pendant un pourcentage de temps plus grand que n'importe quel autre desdits signaux d'entrée, ce niveau rendant non-conducteur ledit transistor MOSFET du second mode de conduction.

$V_{DD}$

2

Q1 Q2 Q3 Q4

OUT

IN1 IN2 IN3 IN4

PRIOR ART
**Fig.1.**

$V_{DD}$

Q8

Q7

Q6

Q5

IN1

Q2 Q3 Q4

OUT

IN2

Q1

IN3

IN4

PRIOR ART
**Fig.2.**

$V_{DD}$

Q15

OUT

Q11 Q12 Q13 Q14

IN1 IN2 IN3 IN4

SG

SIGNAL GENERATOR

*Fig.3.*

$V_{DD}$

Q16

Q15

OUT

Q12 Q13 Q14

Q11

IN1 IN2 IN3 IN4

SG

SIGNAL GENERATOR

*Fig.4.*

FIG.5.